# EUROPEAN PATENT APPLICATION

(11) **EP 3 324 237 A1**
(43) Date of publication of application: **23.05.2018**
(21) Application number: 16824514.0
(22) Date of filing: 13.07.2016
(51) Int. Cl.: G03F 7/004, C08F 290/12, G03F 7/038

(54) **PHOTOSENSITIVE RESIN COMPOSITION**

(30) Priority: 14.07.2015 JP 2015140813
(71) Applicant: Rohm and Haas Electronic Materials LLC, Marlborough, MA 01752 (US)
(72) Inventor: KUSHIDA, Shugaku, Agano-shi Niigata 959-1914 (JP); HAGA, Mitsuru, Agano-shi Niigata 959-1914 (JP); KAINUMA, Kunio, Agano-shi Niigata 959-1914 (JP)
(74) Representative: Houghton, Mark Phillip
(86) International application number: PCT/JP2016/070754
(87) International publication number: WO 2017/010534

(57) **Abstract**

To provide a photosensitive resin composition capable of preventing ion migration while having satisfactory developability and having no cissing. The photosensitive resin composition comprises a reactive polymer having an ethylenically unsaturated double bond group and a carboxyl group; a free radical-based stabilizer; and a photoacid generator. The acid value of the reactive polymer is 40 to 100 mgKOH/g. The chlorine content of the reactive polymer is equal to or less than 150 ppm. The free radical-based stabilizer is selected from a hindered amine or hindered amine derivative. A cured product is obtained by using the photosensitive resin composition.

## Description

### Technical Field

The present invention relates to a photosensitive resin composition and a cured product obtained by using the photosensitive resin composition, and more particularly relates to a photosensitive resin composition and a cured product used in the electrical insulating layer such as an overcoat of the electric wiring.

### Background Art

A metal wire has been widely used as the wiring material of the indium tin oxide (ITO) electrode used in touch panels. However, in recent times, the number of scanning lines of ITO electrode increases with an increase in the size of the screen, thereby increasing the density of peripheral wirings. In other words, it is necessary to reduce the line width and spacing of the wires.

An overcoat, therefore, has been widely used to protect these wirings. However, when the conventional overcoat is used in the high wiring density region, a part of the metal wiring is corroded due to the changes with time. Cause of corrosion is thought to be due to disengagement of the metal ionized from the end of the metal wire and moving towards the counter electrode (ion migration). Ion migration causes the formation of dendrites, causing problems such as malfunctioning of the equipment, short circuit, and the like; therefore, the overcoat not causing ion migration has been demanded.

An overcoat can be produced by exposing, developing, and curing a negative-type photosensitive resin composition; however, it is necessary to introduce a polar group into the polymer in the resin composition to impart developability to the resin, so the carboxyl groups are used as the polar groups. The carboxyl group is, however, highly hygroscopic, due to which moisture may remain in the overcoat of the resin and it may be adsorbed in the environment. This moisture content thus increases the ionic conductivity, thereby causing ion migration.

Japanese Laid-open Patent Publication No. 2013-83996, for example, discloses a touch panel member protecting molybdenum-containing metal wires by using a cured film of the negative-type photosensitive resin composition comprising (A) an alkali-soluble resin having carboxylic acid equivalent of 200 g/mol or more to 400 g/mol or less; (B) a photopolymerization initiator; (C) a multifunctional monomer; and (D) a zirconium compound.

Japanese Laid-open Patent Publication No. 2013-209597 also describes a method for producing a reactive polymer solution that can be used in the binder polymer of the photosensitive resin composition for a protective film for photolithography spacers and color filter, wherein the photosensitive resin composition is formed by dissolving (meth) acrylic acid copolymer having acid value (AVo) of 50 mg KOH/g or more to 350 mg KOH/g or less in an aprotic polar solvent and the moisture content of the (meth) acrylic acid copolymer solution is adjusted within the range indicated with specific formula, and then, subjecting to addition reaction with glycidyl (meth) acrylate in a modification rate of 30 to 70 mol% relative to the acid group of an acrylic acid copolymer. Here, the acid value of the resulting reactive polymer is described as 30 to 200 mg/KOH.

However, according to the studies of the present inventors, it was found that the cured product, which is obtained also by using the reactive polymer having an acid value in the range described in Japanese Laid-open Patent Publication No. 2013-209597, is highly hygroscopic and may cause ion migration. On the other hand, the developability of the photosensitive resin composition is deteriorated with a decrease in the carboxyl group content (expressed as acid value) in the resin composition. It is, therefore, difficult to obtain good developability while simultaneously lowering hygroscopicity of the material.

In addition, in the case of forming a relatively thick cured product by using the conventional photosensitive resin composition, there have been problems that the size becomes uneven due to uneven development of edges of the transfer image to be formed (hereinafter, referred to as 'cissing'). Thus, fine pattern processing was demanded in recent times and its improvement was required.

### Prior Art Documents

### Patent Document

Patent Document 1: Japanese Laid-open Patent Publication No. 2013-83996
Patent Document 2: Japanese Laid-open Patent Publication No. 2013-209597

### Summary of the Invention

### Problem to be Solved by the Invention

Accordingly, the primary object of the present invention is to provide a photosensitive resin composition capable of preventing ion migration of the resulting cured product while maintaining satisfactory developability of the photosensitive resin composition and obtaining a non-cissing transfer image.

### Means for Solving the Problem

The present inventors conducted a study to solve the above-mentioned problems, and found that the developability of the photosensitive resin composition is improved by using a reactive polymer, which has an acid value within the specific range lower than commonly used and a low chlorine content, in combination with a specific stabilizer; the ion migration of the cured product is prevented with a satisfactory developability of the photosensitive resin composition; and a non-cissing transfer image is obtained. Thus, the present invention was accomplished based on these findings.

In other words, the present invention relates to a photosensitive resin composition comprising a reactive polymer having an ethylenically unsaturated double bond and a carboxyl group; a free radical-based stabilizer; and a photoacid generator. The acid value of the reactive polymer is 40 to 100 mgKOH/g. The chlorine content of the reactive polymer is equal to or less than 150 ppm. The free radical-based stabilizer is selected from a hindered amine or hindered amine derivative.

The reactive polymer is preferably obtained by addition reaction of an epoxy compound having an ethylenically unsaturated double bond with a polymer A which is polymerized from a monomer containing at least one acrylic acid and methacrylic acid. In addition reaction, a tertiary amine is preferably used as a catalyst. The tertiary amine that can be used preferably includes tertiary amine selected from triethylamine, tri-isopropyl amine, and dimethyl amino pyridine.

The photosensitive resin composition of the present invention preferably has 100 ppm or less chlorine content per solid content of the resin composition. The photosensitive resin composition of the present invention may further contain a crosslinking agent.

The present invention further relates to a cured product obtained from above photosensitive resin composition and an overcoat formed from the above photosensitive resin composition. The overcoat is formed on the wiring, which is made of a material selected from copper, silver, or an alloy containing these. Said wiring is connected to at least one indium tin oxide (ITO) electrode, which is used for a touch panel.

### Brief Description of the Drawings

[Fig. 1] Fig. 1 is a photomicrograph of the transfer image obtained in Example 1.
[Fig. 2] Fig. 2 is a photomicrograph of the transfer image obtained in Comparative Example 3.

In the present specification, °C is degree Celsius, g/L is gram per liter, ml/L is milliliter per liter, µm is micrometer, and m/min is meters per minute.

The photosensitive resin composition of the present invention contains a reactive polymer having an ethylenically unsaturated double bond and a carboxyl group, wherein the acid value of the reactive polymer is 40 to 100 mgKOH/g and the chlorine content is equal to or less than 150 ppm. The reactive polymer undergoes a crosslinking reaction by exposure to form a polymer insoluble in the developing solution.

Examples of the reactive polymer having an ethylenically unsaturated double bond and a carboxyl group include those having ethylenically unsaturated double bond introduced into the acrylic resin. Among these, the reactive polymer having an ethylenically unsaturated double bond introduced in the structure thereof is preferred. The bond is introduced by reacting an epoxy compound having an ethylenically unsaturated double bond such as glycidyl methacrylate (GMA) with a polymer (hereinafter, referred to as polymer A) in the presence of catalyst. Here, the polymer is obtained by using a monomer that contains acrylic acid and/or methacrylic acid as the raw material. When GMA is used, it is considered that the glycidyl ring in GMA reacts with the carboxyl group in the polymer A, thereby introducing an unsaturated double bond in the reactive polymer.

Other monomers that can be used with acrylic acid and/or methacrylic acid in the preparation of polymer A include, but are not limited to, alkyl esters or aromatic esters of acrylic acid and/or methacrylic acid, maleimides, inert monomers such as styrene and the like, and hydroxides such as hydroxide alkyl ester or hydroxide styrene. In regards to the molar ratio of the monomers used in preparing the polymer A, usually acrylic acid and/or methacrylic acid is from 10 to 55 pts. wt. and the total of other inert monomers and/or hydroxides is from 45 to 90 pts. wt. with respect to the polymer A100 pts. wt.. Preferably acrylic acid and/or methacrylic acid is from 15 to 35 pts. wt. and the total of other inert monomers and/or hydroxides is from 65 to 85 pts. wt..

The epoxy compound having an ethylenically unsaturated double bond that can be used includes GMA as well as 4- (oxirane-2-yl- methoxy) butyl acrylate, 3, 4-epoxycyclohexylmethyl methacrylate.

When GMA is used as the epoxy compound having an ethylenically unsaturated double bond, the amount of GMA used is preferably in the range from 5 to 40 pts. wt. to polymer A 100 pts. wt..

A catalyst can be used when carrying out an addition reaction of an epoxy compound having an ethylenically unsaturated double bond on a polymer A. A tertiary amine is preferably used as the catalyst. The tertiary amine with high volatility and high activity is preferred as the catalyst. Specific examples of tertiary amine include triethylamine described in Japanese Laid-open Patent Publication No. 2004-107401 as well as triisopropylamine and dimethylaminopyridine. By using above amines as the catalyst, an addition reaction product having high molecular weight and low dispersity can be obtained. The amount of catalyst used may be an amount commonly used in the industry, i.e. usually from 0.1 to 5 wt.% relative to the weight of the polymer A, preferably from 0.1 to 3 wt.%.

The acid value of the reactive polymer used in the present invention is from 40 to 100 mgKOH/g, preferably from 55 to 85 mg KOH/g. The acid value is measured by neutralization titration of potassium hydroxide. If acid value exceeds 100 mgKOH/g, the resulting cured product has high hygroscopicity, which can cause migration. On the other hand, if the acid value is lower than 40 mgKOH/g, the developability of the photosensitive resin composition excessively declines; so the desired transfer image cannot be obtained. On the contrary, adjustment of the acid value within the above-mentioned range and combination of the reactive polymer with a free radical-based stabilizer of the present invention can suppress the hygroscopicity of the resulting cured product and obtain the desired developability of photosensitive resin composition.

In order to adjust the acid value of the reactive polymer within the above-mentioned range, the amount of carboxyl group in the reactive polymer is adjusted. The method for adjusting the amount of carboxyl group includes a method for adjusting the content ratio of the monomer having a carboxyl group from among the monomers for producing polymer A, and a method for adjusting the addition amount of a compound having an ethylenically unsaturated double bond group when reacting polymer A with a compound having ethylenically unsaturated double bond group such as GMA. Either or both methods can be used in the present invention.

The molecular weight of the reactive polymer used in the present invention (weight average molecular weight) is usually from 5,000 to 20,000, preferably from 8,000 to 15,000. Note that, the weight average molecular weight is a GPC measurement when using polystyrene as a reference material.

The amount of reactive polymer used is usually 20 to 95 pts. wt., preferably 40 to 80 pts. wt. with respect to 100 pts. wt. of solid content of the photosensitive resin composition.

The photosensitive resin composition of the present invention contains a free radical-based stabilizer in addition to the above-mentioned reactive polymer. The free radical-based stabilizer is selected from a hindered amine or hindered amine derivative. The stabilizer is also referred to as a reaction control agent and serves as a radical scavenger.

A photoacid generator in the photosensitive resin composition generates a radical by exposure, and the generated radical is inactivated by oxygen in the photosensitive resin composition. Therefore, in the case of forming a relatively thick negative-type photosensitive resin film using the photosensitive resin composition of the present invention, the oxygen content differs in the deep portion and the surface vicinity of the film; hence, the radicals are easily inactivated in the vicinity of the surface of the photosensitive resin film where oxygen content is high, and the reactive polymer is less likely to be three-dimensionally cross-linked; however, a phenomenon is generated that easily causes cross-linking in the deep portion of the photosensitive resin film having less oxygen content. Therefore, when the exposure conditions are set in accordance with the vicinity of the surface of the photosensitive resin film, there have been problems such as the crosslinking of the deep portion of film progresses as compared to the vicinity of the surface, so the end portion of the image after development becomes uneven, and the accurate fine image cannot be formed (cissing).

In the case of using a compound selected from hindered amine or hindered amine derivative as the free radical-based stabilizer, a non- cissing, fine transfer image having high precision can be formed.

The hindered amine or hindered amine derivative is a generic term for a compound that has an organic or inorganic bulky structure directly attached to at least one place of three joint places of the nitrogen atom showing an amine structure. More specifically, the structure of the secondary or tertiary amine known as a hindered amine light stabilizer (HALS) is included, for example, a structure (such as TEMPO, 4-hydroxy -TEMPO) wherein one position of the nitrogen atom is substituted with an oxy radical is well known.

The amount of the hindered amine or hindered amine derivative used is usually 5.0 to 0.001 pts. wt., preferably 1.0 to 0.05 pts. wt. with respect to 100 pts. wt. of solid content of the photosensitive resin composition.

The resin composition of the present invention preferably has low chlorine content as much as possible; specifically, the chlorine content per solid content in the resin composition is preferably 100 ppm or less. High chlorine content increases the amount of chlorine ions, which are conductive ions in the resin composition, thereby causing migration. More preferably, the chlorine content of per solid content in the resin composition is 80 ppm or less. The chlorine content in the resin composition can be measured by an ion chromatography after capturing ions contained in generated gas in water by burning the resin solution. At that time, in addition to chlorine ions, epichlorohydrin residue and the like are also detected together, so the total chlorine content in the resin composition is measured including these. In order to reduce the chlorine content in the resin composition as much as possible, i.e. making the chlorine content 100 ppm or less to a solid content, the material having less chlorine content is preferably used as the raw material of the resin composition as well as the generation process not producing chlorine ions is preferably selected.

Lowering the chlorine content in the reactive polymer is the most efficient way to lower the chlorine content in the resin composition. The reactive polymer having chlorine content equal to or less than 150 ppm is used in the present invention. The chlorine content of the reactive polymer is preferably 100 ppm or less, more preferably 50 ppm or less, and further preferably 20 ppm or less. Using such a reactive polymer can suppress the chlorine content in the photosensitive resin composition.

In order to reduce the chlorine content in the reactive polymer, the chlorine content in each of the components contained in the reactive polymer may be reduced as much as possible. For example, in the reaction of polymer A with a compound having an ethylenically unsaturated double bond group, when using the quaternary ammonium salt and not the tertiary amine as the catalyst, the chlorine ions usually contained in quaternary ammonium salt remain in the reactive polymer and consequently unfavorably mix into the resin composition. In addition, the compound having low chlorine content is also preferably used as the compound having an ethylenically unsaturated double bond group to be reacted with the polymer A. Generally used GMA (for example, glycidyl methacrylate manufactured by Dow Chemical Co.) is manufactured by Epichlor method, wherein chlorine ions, epichlorohydrin, or chlorinated intermediates are mixed or remained. It is therefore difficult to remove these chorine impurities after synthesizing resin composition, which is also undesirable from the economic aspect. In the present invention, it is preferable to use GMA which is high in purity and has low concentration of chloride ions or epichlorohydrin. These materials can also be selected from among commercially available products. Examples of the commercially available products include Blemmer GH and Blemmer GS manufactured by NOF Co., Ltd., SY monomer G manufactured by Sakamoto Yakuhin Kogyo Co., Ltd., and the like.

The resin composition of the present invention contains a photoacid generator. Well-known photoacid generators can be used. Examples include biimidazole compounds, benzene compounds, acetophenone compounds, oxime ester compounds, benzophenone compounds, α-diketone compounds, polynuclear quinone compounds, xanthone compounds, phosphine compounds, triazine compounds, and the like. Of these, acetophenone compounds and oxime ester compounds are preferred. These can be used alone or in combination of a plurality. Examples of the acetophenone compounds include α-hydroxyacetophenone compounds, α-aminoacetophenone compound, and the like; however, other compounds may also be used. Specific examples of the α-hydroxyacetophenone compounds include 1-hydroxycyclohexyl phenyl ketone, 2-hydroxy-2-methyl- phenyl-propan-1-one. Specific examples of α-aminoacetophenone compound include 2-benzyl-2-dimethylamino-1- (4-morpholinophenyl)-butanone-1,2-dimethylamino-2- (4-methyl-benzyl) - 1- (4-morpholine-4-yl-phenyl) - butane-1-one and the like. Specific examples of the oxime ester compounds include 1, 2-octanedione, 1- [4- (phenylthio) phenyl -, 2- (O-benzoyl oxime)], ethanone, 1- [9-ethyl-6- (2-methylbenzoyl)-9H-carbazole - 3-yl] -, 1- (O-acetyl oxime), and the like.

The content of the photoacid generator is usually from 0.5 to 20 pts.wt., preferably from 1 to 10 pts. wt. with respect to 100 pts. wt. of solid content of the crosslinking agent and the photopolymerizable resin composition.

The resin composition of the present invention is preferably a negative type and can contain a crosslinking agent. The compound that can be used as the crosslinking agent includes a polymerizable compound having at least two ethylenically unsaturated double bonds; and the polyfunctional acrylic or methacrylic acid esters are preferred. Examples of commercially available bifunctional (meth) acrylate include Aronix M-203S, Aronix M-215 (manufactured by Toagosei Chemical Industry Co., Ltd.), KAYARA R-604, KAYARA FM-400, (manufactured by Nippon Kayaku Co., Ltd.), Light Ester DCP-A (manufactured by Kyoeisha Chemical Co., Ltd.), and the like. Examples of commercially available tri- or higher functional (meth) acrylate include Aronix M-403, M-510, M-510, M-8030, and M-8060 (manufactured by Toagosei Chemical Industry Co., Ltd.), KAYARAD TMPTA, KAYARAD DPHA, and KAYARAD FM-700 (manufactured by Nippon Kayaku Co., Ltd.), light acrylate PE-3A and light acrylate DPE-6A (manufactured by Kyoeisha Chemical Co., Ltd.), and the like. The content of the crosslinking agent is usually from 20 to 80 pts. wt., preferably from 30 to 70 pts. wt. with respect to 100 pts. wt. of total crosslinking agent and the photopolymerizable resin composition.

The resin composition of the present invention, in addition to above ingredients, may contain a solvent, an adhesion enhancer, a surface leveling agent, a sensitizer, a dispersoid of metal oxide, and the like if necessary.

The resin composition of the present invention can be used as a so-called resist (a photosensitive resin film). The resin composition of the present invention is specifically applied onto a base substrate such as glass, plastic such as PET resin, and the like by means of spin coating, roll coating, slit coating, and the like. After application, it is pre-baked by using an oven. Prebaking is preferably carried out for 1 to 3 minutes on a hot plate heated at 80 to 120°C. The thickness of the photosensitive resin film obtained after prebaking is preferably 1 to 5 µm.

Thereafter, the obtained photosensitive resin film is irradiated (exposed) with light through a mask and developed. In the case of organic based development, TMAH aqueous solution is preferably used and in the case of inorganic based development, an alkaline aqueous solution mainly composed of potassium hydroxide, sodium hydroxide, sodium bicarbonate, and the like is preferably used; and the development is preferably carried out for 40 to 180 seconds at room temperature. The concentration of the alkaline aqueous solution is preferably 0.05 wt.% in the case of potassium hydroxide. The photosensitive resin film is dissolved leaving the exposed portion due to development, and the photosensitive resin film of the exposed portion remains on the base substrate as an image. Thereafter, it is subjected to baking treatment at about 120°C to 240°C if required. The treatment time when performing baking treatment using a convection oven at low temperature of about 120°C and high temperature of about 220 to 240°C is preferably about 60 minutes and 30 minutes, respectively.

The resin composition obtained in the present invention can be used as a protective material (an overcoat) for metal wires connected to the ITO electrodes that are used in touch panel. As described above, in recent times, the number of scanning lines of ITO electrode increases with an increase in the size of the screen, so it is necessary to reduce the line width and spacing of the wires. However, if the conventional overcoat is used to protect these wirings, ion migration occurs, which may cause the formation of dendrites causing problems such as malfunctioning of the equipment, short circuit, and the like. Since the cured product using the photosensitive resin composition of the present invention hardly causes ion migration, it is suitable for such applications. For making an overcoat, a metal wiring and an ITO electrode are formed on the substrate such as glass and the resin composition of the present invention is applied thereon. Then, prebaking, exposure, development, and baking treatment if required are performed by the same procedure as mentioned above to form an overcoat having electrical insulation on the wiring. Metal wiring is made of a material selected from copper, silver, or an alloy containing these. Metal wiring is connected to at least one ITO electrode.

The resin composition of the present invention can also be used as a jumper material for metal wiring and a protective material for decorative layer.

When the resin composition is used as the protective material for decorative layer, a base substrate is used which is partially decorated with an organic or inorganic paint or a colored resist. Coating, prebaking, exposure, development, and baking treatment are performed according to the above-described treatment method. Exposure may be carried out in a range that covers the entire surface of the touch panel. After mounting the protective material for decorative layer, steps such as formation of metal wiring, transparent electrode, and jumper material, overcoat treatment, and the like are performed. Performing this treatment can suppress the volatilization of impurities and the like contained in the decorative layer and can prevent the problems such as disconnection in the subsequent wiring and electrode formation. This treatment can also alleviate the difference in level between the decorative layer and the base, and can prevent the occurrence of trouble in wiring and electrode which causes difference in level.

When the resin composition is used as the jumper material for wiring, the treatment is performed according to the above method onto the substrate mounted with wiring made of a material selected from metals such as molybdenum, aluminum, copper, and silver or alloy containing these, the transparent metal oxide, such as ITO, and the carbon-based conductive transparent such as graphine and carbon nanotube. In some cases, the base substrate is mounted with above decorative layer and the protective material for decorative layer. So it may be treated in the same manner as in the above case "When the resin composition is used as the protective material for decorative layer", except forming a fine pattern by mask exposure.

### Examples

The present invention will now be explained based on the examples, but is not limited thereto.

A reactive polymer 1 was prepared in accordance with the method described in Japanese Laid-open Patent Publication No. 2004-107401. The reactive polymer 1 is obtained by an addition reaction of a high purity GMA (Blemmer GS (manufactured by NOF Co., Ltd.)) with a polymer consisting methyl methacrylate, methacrylic acid, and benzyl methacrylate similar to Japanese Laid-open Patent Publication No.2004-107401, by using triethylamine as the catalyst. The acid value and the chlorine content of the reactive polymer 1 were 78 mgKOH/g and 1.6 ppm, respectively. Note that when a common product (glycidyl methacrylate manufactured by Dow Chemical Co.) was used instead of high purity GMA, the chlorine content was 446 ppm, and when a quaternary ammonium salt, tetramethylammonium chloride, was used instead of triethylamine as an addition catalyst, the chlorine content was 2730 ppm.

### Example 1

47.8 g of above reactive polymer 1 (solid content concentration of 36.5%); 36 mg of 4-hydroxy-TEMPO [manufactured by Wako Pure Chemical Industries, Ltd., 4HTEMPO (4-hydroxy-2, 2, 6, 6-tetramethylpiperidine-N-oxyl)] as a hindered amine free radical-based stabilizer; 0.29 g of IRGACURE-379 [manufactured by BASF Corp., 2-dimethylamino-2- (4-methyl-benzyl) -1-(4-morpholine-4-yl-phenyl)-butan-1-one] as a photoacid generator; 0.29 g of IRGACURE OXE-01 [manufactured by BASF Corp., 1, 2-octanedione, 1- [4- (phenylthio) phenyl -, 2-(O-benzoyl oxime)]] and 0.29 g of IRGACURE OXE-02 [manufactured by BASF Corp., ethanone, 1- [9-ethyl-6- (2-methylbenzoyl)-9H-carbazol-3-yl]-, 1- (O-acetyl oxime); 5.8 g of KAYARAD DPHA [manufactured by Nippon Kayaku Co., Ltd., dipentaerythritol hexaacrylate] and 5.8 g of Aronix M-520 (manufactured by Toagosei Co., Ltd., polybasic acid-modified acrylic oligomer) as a crosslinking agent; 32.8 g of PGMEA (propylene glycol mono methyl ether acetate) and 6.8 g of PGME (propylene glycol monomethyl ether) as a solvent were mixed to prepare a photosensitive resin composition. The resulting photosensitive resin composition was applied onto a glass substrate and a silicon substrate by using a spin coater (D-SPIN SK-W60A-AVP, manufactured by SOKUDO Ltd.), and then it was prebaked at 90°C for two minutes on a hot plate that was attached to the spin coater to obtain a photosensitive resin film. The thickness of the photosensitive resin film was measured with an optical interference film thickness meter (Lambda Ace VM-2010, manufactured by Dainippon Screen Mfg. Co., Ltd.). The rotational speed of the spin coater was adjusted such that the thickness after prebaking becomes 1.8 and 3.5 microns.

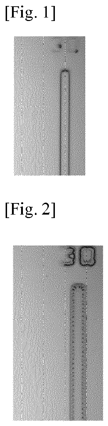

For the obtained photosensitive resin film, a mask pattern exposure was performed using ultraviolet exposure equipment (MA-1200, manufactured by DNK). Using a high pressure mercury lamp as the light source, the exposure time was adjusted such that the accumulated amount of exposure becomes 50 mJ/cm². For exposure energy, i-line wavelength (365 nm) was measured by using a luminometer with an ultraviolet exposure meter (UV-M03A, manufactured by Oak Seisakusho Ltd.) and an ultraviolet photodetector (UV-SN35, manufactured by Oak Seisakusho Ltd.). In the mask pattern exposure, the mask (manufactured by BENCHMARK Technologies) that can transfer different exposure energies from 100% to 10% in a bulk, with respect to the incident energy, by changing the transmittance by halftoning, was used. The spacing between the substrate and the mask during mask exposure was 150 microns. The substrate after exposure treatment was then immersed into a potassium hydroxide aqueous solution, which was adjusted to 0.05 wt.%, for 120 seconds at 23°C to carry out development. After development, a convection clean oven (DT-410, manufactured by Yamato Scientific Co., Ltd.) heated at 230°C was used to carry out baking treatment for 30 minutes at a temperature of 230°C, whereby a trench (a cured product) of width 30 µm was obtained. Fig. 1 shows a photomicrograph of the obtained cured product (Magnification: 20 times, opening width 30 µm, exposure amount 50 mJ/cm², and film thickness 1.8 microns).

**[Table 1]**

| Composition | Example 1 | Example 2 | Example 3 | Example 4 | Comparative Example 1 | Comparative Example 2 | Comparative Example 3 |
|---|---|---|---|---|---|---|---|
| Resin 1/g | 47.8 | 46.9 | 47.7 | 47.7 | 47.7 | 47.7 | 47.9 |
| DPHA /g | 5.8 | 5.7 | 5.8 | 5.8 | 5.8 | 5.8 | 5.8 |
| M-520 /g | 5.8 | 5.7 | 5.8 | 5.8 | 5.8 | 5.8 | 5.8 |
| IRGACURE-379 /g | 0.29 | 0.43 | 0.32 | 0.32 | 0.32 | 0.32 | 0.29 |
| OXE-01/g | 0.29 | 1.00 | 0.00 | 0.00 | 0.00 | 0.00 | 0.29 |
| OXE-02/g | 0.29 | 0.00 | 0.64 | 0.64 | 0.64 | 0.64 | 0.29 |
| 4H-TEMP0 / mg | 36 | 57 | 41 | 20 | - | - | - |
| HQ/mg | - | - | - | - | - | 0.015 | - |
| Q/PI molar ratio | 0.10 | 0.10 | 0.05 | 0.10 | - | 0.10 | - |
| PGMEA/g | 32.8 | 33.3 | 32.9 | 32.9 | 32.8 | 32.8 | 32.8 |
| PGME/g | 6.8 | 6.9 | 6.9 | 6.9 | 6.8 | 6.8 | 6.8 |

| | | | | | | | |
|---|---|---|---|---|---|---|---|
| HQ: Hydroquinone (manufactured by Sigma Aldrich Q/PI molar ratio: Molar ratio of stabilizer to photopolymerization initiator (No. of moles of stabilizer/ No. of moles of photopolymerization initiator) | | | | | | | |

### Examples 2 to 4 and Comparative Examples 1 to 3

The raw materials described in Table 1 were used to obtain a cured product by performing same operations as in Example 1. Note that in Examples 3 and 4 and Comparative Examples 1 and 2, a silicon wafer was used instead of the glass substrate and only opening width and pattern height (residual film rate) were examined. Fig. 2 shows a photomicrograph of the cured product obtained in Comparative Example 3 (Magnification: 20 times, opening width 30 µm, exposure amount 50 mJ/cm², and film thickness 1.8 microns). As shown in Fig. 2, the obtained cured product has development defect in the periphery of an opening.

"Evaluation of cissing": A 30 microns wide light shielding mask pattern was used to observe an image transferred on the glass substrate with an optical microscope (H300M, manufactured by Lasertec Corporation). At this time, the coating thickness of the photosensitive resin film was found to be 3.5 and 1.8 microns and the exposure energy was found to be 50 mJ/cm² and 40 mJ/cm².

"Opening width": With the above-mentioned mask and exposure amount, the image transferred on the silicon substrate was observed with an optical microscope (H300M, manufactured by Lasertec Corporation). The opening size was measured by the software (LM-EYE) attached with the same microscope.

"Pattern height" was measured by an optical interference film thickness meter (Lambda Ace VM-2010, Dainippon Screen Mfg. Co., Ltd.).

Results are shown in Table 2.

**[Table 2]**

| | Evaluation item | Exposure amount (mJ/cm2) | Example 1 | Example 2 | Example 3 | Example 4 | Comparative Example 1 | Comparative Example 2 | Comparative Example 3 |
|---|---|---|---|---|---|---|---|---|---|
| 3.5 | Cissing | 50 | None | None | --- | --- | --- | --- | Yes |
| | | 40 | None | None | --- | --- | --- | --- | Yes |
| | | 50 | None | None | --- | --- | --- | --- | Intense |
| | | 40 | None | None | --- | --- | --- | --- | Intense |
| 3.5 | Opening width/ µm | 50 | 12.4 | 13.7 | 9.9 | 7.3 | 0.0 | 0.0 | 8.2 |
| | | 40 | 12.6 | 14.5 | 10.6 | 9.8 | 5.5 | 6.1 | 9.7 |
| | Pattern height / µm | 50 | 2.39 | 2.34 | 2.67 | 2.71 | 2.71 | 2.62 | 2.47 |
| | | 40 | 2.39 | 2.19 | 2.62 | 2.64 | 2.64 | 2.57 | 2.42 |

Examples 1 and 2 showed no occurrence of cissing which is of concern after development; however, the Comparative Example 3 not using hindered amine stabilizer showed occurrence of cissing. In addition, the problem of cissing is significant if the film thickness is reduced.

Examples 3 and 4 and Comparative Examples 1 and Comparative Example 2 have same composition except the stabilizer component. The amount of the stabilizer was added in a molar ratio with respect to the photopolymerization initiator. In Examples 3 and 4, wherein hindered amine was added as a stabilizer, the opening width and the pattern height were maintained; whereas in Comparative Example 1 not using stabilizer, the opening size was not ensured (not open). On the other hand, when (phenolic system) other than hindered amine was used as stabilizer, the pattern height was lowered as compared to Comparative Example 1; thus, it can be confirmed that there was certain influence on the polymerization reaction by a photopolymerization initiator. However, the function to control opening size was significantly reduced as compared to Example 3. These results showed that the hindered amine is suitable as a stabilizer for use in the present compositions.

### Example 5

### Preparing a comb-shaped electrode for the migration test

A substrate, which was sequentially mounted with a silicon nitride film with a film thickness of 1000 nm, a titanium nitride film with a film thickness of 20 nm by sputtering method, and a copper film with a thickness of 300 nm by sputtering method, was prepared on the silicon wafer substrate. In order to remove the copper layer acid value on the surface of the substrate, the substrate was immersed in a 10 wt.% sulfuric acid aqueous solution for one minute at room temperature. The substrate was then washed under a stream of pure water and the surface was dried off. A commercially available resist (LC-135, manufactured by Rohm and Haas Electronic Materials Co., Ltd.) was applied on the substrate by using a spin coater (D-SPIN SK-W60A-AVP, manufactured by SOKUDO Ltd.). The substrate was then prebaked on a hot plate for 90 seconds at 110°C to obtain a resist film. The thickness of the resist film was measured by an optical interference film thickness meter (manufactured by Lasertec Co., Ltd.). The rotation speed was adjusted such that the film thickness after prebaking becomes 5 microns. For the obtained resist film, a mask pattern exposure was performed using ultraviolet exposure equipment (MA200, manufactured by SUSS Micro Tec/Karl Suss Inc.). The substrate after exposure treatment was then immersed into a TMAH (tetramethyl ammonium hydride) aqueous solution, which was adjusted to 2.38 wt.%, for 150 seconds at 23°C to carry out development. The resulting resist image was used as a mask and the exposed copper portion was removed by immersing it into an etching solution (60 g/L aqueous solution of PREPOSIT ETCH 748 manufactured by Rohm and Haas Electronic Materials Co., Ltd.,) for two minutes at temperature of 23°C. The titanium nitride layer was removed by dry etching method (oxygen/carbon tetrafluoride mixture).

After removing the resist film that was used as a mask, the surface was again immersed in the dilute sulfuric acid (10 wt.% sulfuric acid aqueous solution) for 5 seconds at room temperature and then washed. Spacing between the prepared positive and negative electrodes was 30 microns.

### Performing migration test

### Example 6

To the substrate fitted with a comb-shaped electrode prepared in Example 5, the photosensitive resin composition prepared in Example 1 was applied using a spin coater (D-SPIN SK-W60A-AVP, manufactured by SOKUDO Ltd.). It was then prebaked on a hot plate (same as above) for two minutes at 90°C to obtain a photosensitive resin film. The thickness of the photosensitive resin film was measured by an optical interference film thickness meter (manufactured by Lasertec Co., Ltd.). The rotation speed was adjusted such that the film thickness after prebaking becomes 1.8 microns. For the obtained photosensitive resin film, the transfer mask was used to shield the probe mounting position of comb-shaped electrode and other entire surface was exposed. Except for these, the photosensitive resin film was subjected to ultraviolet curing, removal of the surface uncured portion by the development treatment, and baking treatment in the same manner as in Example 1. At this time, the photosensitive resin film is not attached to the probe mounting portion. The substrate was immersed in the dilute sulfuric acid (10 wt.% sulfuric acid aqueous solution) for one minute at room temperature and then surface was washed. After washing, a terminal for probe attachment was bonded using a solder paste. After bonding, the substrate was calcined by heating for 5 minutes in a conveyor oven heated to 240°C. The flux produced after the solder paste calcination was removed by brush washing using a stripping solution (SHIPLEY BPR PHOTOSTRIPPER, manufactured by Rohm and Haas Electronic Materials Co., Ltd.) heated to 50°C. A test piece was placed into withstand constant temperature and humidity chamber. A voltage of 5 V was applied between the probes as well as the constant temperature and humidity chamber was operated at temperature of 130°C and humidity of 85%. 100 hours continuous voltage application and high-temperature and high-humidity operation were continued, and before and after appearance was compared and evaluated. The results are shown in Table 3.

### Comparative Example 4

A photosensitive resin composition was prepared in the composition similar to the resin composition of Example 1 except using the conventional reactive polymer instead of reactive polymer 1 obtained in synthesis example 1. Tests were performed in the same manner as in Example 6 and the test results are shown in Table 3. Note that the chlorine ion content in the prepared photosensitive resin composition of the Comparative Example 4 was measured by an ion chromatography, which was found to be 490 ppm. Since the solid content concentration of the composition of Comparative Example 4 was 30 wt.%, it can be converted if chlorine of about 1600 ppm is contained per solid content. On the other hand, the total chlorine content was measured in the same manner as the photosensitive resin composition prepared in Example 1 and the measured value was found to be 17 ppm (68 ppm in terms of value per solid content).

**[Table 3]**

| | Example 6 | Comparative Example 4 |
|---|---|---|
| Resin | Resin 1 | Conventional product |
| Chlorine content per resist solid content | 65 ppm | 1630 ppm |
| Appearance degradation, dendrimer occurrence | No | Yes |

## Claims

1. A photosensitive resin composition comprises a reactive polymer having an ethylenically unsaturated double bond and a carboxyl group; a free radical-based stabilizer; and a photoacid generator. The acid value of the reactive polymer is 40 to 100 mgKOH/g. The chlorine content of the reactive polymer is equal to or less than 150 ppm. The free radical-based stabilizer is selected from a hindered amine or hindered amine derivative.

2. The photosensitive resin composition according to claim 1, wherein the reactive polymer is obtained by addition reaction of an epoxy compound having an ethylenically unsaturated double bond with a polymer A which is polymerized from a monomer containing at least one acrylic acid and methacrylic acid. In addition reaction, a tertiary amine is used as a catalyst.

3. The photosensitive resin composition according to claim 2, wherein the tertiary amine is selected from triethylamine, tri-isopropyl amine, and dimethyl amino pyridine.

4. The photosensitive resin composition according to claim 1, wherein the chlorine content in the photosensitive resin composition is 100 ppm or less per solid content of the resin composition.

5. The photosensitive resin composition according to any of claims 1 to 4 further comprises a crosslinking agent.

6. A cured product obtained from photosensitive resin composition according to any of claims 1 to 5.

7. An overcoat is formed on the wiring, which is made of a material selected from copper, silver, or an alloy containing these. The overcoat is formed from the photosensitive resin composition according to any of claims 1 to 5. Said wiring is connected to at least one indium tin oxide (ITO) electrode, which is used for a touch panel.
